# EUROPÄISCHE PATENTSCHRIFT

(11) **EP 2 277 198 B1**
(45) Veröffentlichungstag und Bekanntmachung des Hinweises auf die Patenterteilung: **11.07.2018**
(21) Anmeldenummer: 09745706.3
(22) Anmeldetag: 11.05.2009
(51) Int. Cl.: H01L 25/075, H01L 33/48, H01L 33/62, H01L 33/64

(54) **LEUCHTDIODEN-ANORDNUNG**
ARRANGEMENT OF LIGHT-EMITTING DIODES
ARRANGEMENT DE DIODES ÉLECTROLUMINESCENTES

(30) Priorität: 13.05.2008 DE 102008023369
(43) Veröffentlichungstag der Anmeldung: 26.01.2011
(73) Patentinhaber: Siemens Aktiengesellschaft, 80333 München (DE)
(72) Erfinder: GERHARD, Detlef, 81829 München (DE)
(86) Internationale Anmeldenummer: PCT/EP2009/055650
(87) Internationale Veröffentlichungsnummer: WO 2009/138374

(56) Entgegenhaltungen:
- EP-A- 0 921 568
- WO-A-02/43134
- JP-A- H0 758 411
- US-A- 3 622 906
- US-A1- 2003 151 343
- US-A1- 2005 254 539

## Beschreibung

Die Erfindung betrifft eine Anordnung einer Vielzahl von LEDs (Licht emittierende Dioden), die auf einem gemeinsamen Träger aufgebracht sind, ungefähr in die gleiche Richtung abstrahlen und somit eine flächig ausgedehnte Lichtquelle bilden.

Beim Aufbau von sehr intensiven Lichtquellen basierend auf der Zusammenstellung einer Vielzahl von Leuchtdioden (im Folgenden als LED-Chips oder kurz als LEDs bezeichnet) werden mehrere dieser Elemente auf einem gemeinsamen Träger aufgebracht. Die Kontaktierung geschieht außerhalb des gemeinsamen Trägers, wobei die einzelnen Elemente miteinander verbunden werden. Für kleinere Anordnungen, bei denen beispielsweise zwei auf drei LEDs oder zwei auf n LEDs umfasst sind, mag dieses Verfahren gut anwendbar sein.

Für eine bekannte zweidimensionale Belegung einer Fläche mit LEDs werden bisher Zwischenräume zwischen den LEDs für die Montage der Vielzahl von LEDs vorgesehen, wie dies beispielsweise gemäß der US 2004/0233671 A1 beschrieben ist. Es ist aus US 3622906 A bekannt, dass LED-Chips auf mehreren Stufen eines thermisch-leitenden Substrates angeordnet werden können, wobei die elektrische Schaltung der LED-Chips zumindest seriell ausgelegt ist.

In einem benachbarten Anwendungsgebiet, offenbaren US 2005/254539 A1 und JP H07-58411 A Laserdioden-Anordnungen.

Außerdem ist es aus der EP 0 921 568 A2 bekannt, dass LEDs auf mehreren Stufen eines Substrates angeordnet werden können, wobei zur Kontaktierung der LEDs Leiterbahnen auf den unterschiedlichen Stufen des Substrates vorgesehen werden können, die aus Metallisierungen des Substrates gebildet wurden.

Die je nach Entwicklungszustand beabsichtigte dichte Packung der Licht emittierenden Dioden führt weiterhin zu einer Wärmeentwicklung, die entsprechend berücksichtigt werden muss.

Bisherige Lösungsmöglichkeiten wurden beispielsweise durch die Vergrößerung der Chipfläche gesucht, über die das Licht der LED abgestrahlt wird. Großflächige LEDs sind jedoch schwerer herzustellen und die Ausbeute sinkt mit zunehmender Größe stark ab. In der Praxis bedeutet dies, dass hohe Produktionskosten zu berücksichtigen sind. Eine weitere Möglichkeit, die Lichtausbeute einer flächigen Anordnung von Lichtquellen zu optimieren, besteht darin, dass die LEDs auf einem gemeinsamen Träger platziert werden. Dies hat allerdings den Nachteil, dass die Packungsdichte der LEDs je nach Flächeneinheit nicht optimal ist.

Der Erfindung liegt die Aufgabe zugrunde, eine LED-Anordnung bereitzustellen, die einen möglichst kompakten Aufbau bei gleichzeitig günstiger Wärmeabfuhr aufweist.

Die Lösung dieser Aufgabe geschieht durch die Merkmalskombination des Patentanspruchs 1. Vorteilhafte Ausgestaltungen sind den Unteransprüchen zu entnehmen.

Der Erfindung liegt die Erkenntnis zugrunde, dass LEDs auf einer flächigen Anordnung derart dicht gepackt werden können, dass sie eine optimale flächige Beleuchtung mit Abstrahlung in einer Richtung darstellen. Die LEDs werden dabei nicht vollständig auf einer gemeinsamen Ebene montiert, sondern weisen in Abstrahlrichtung Höhenunterschiede auf. Die nebeneinander angeordneten LEDs bleiben jedoch in ihrer relativen Ausrichtung zueinander bezogen auf die laterale Anordnung unverändert positioniert bzw. entsprechend der Erfindung dicht oder eng gepackt.

Entsprechend der Erfindung wird eine Sandwichbauweise für den Träger verwendet, die aus mehreren Metallfolien (auch als Metallschichten bezeichnet) besteht, wobei zwischen den Folien jeweils eine Isolierschicht zwischen gelegt ist.

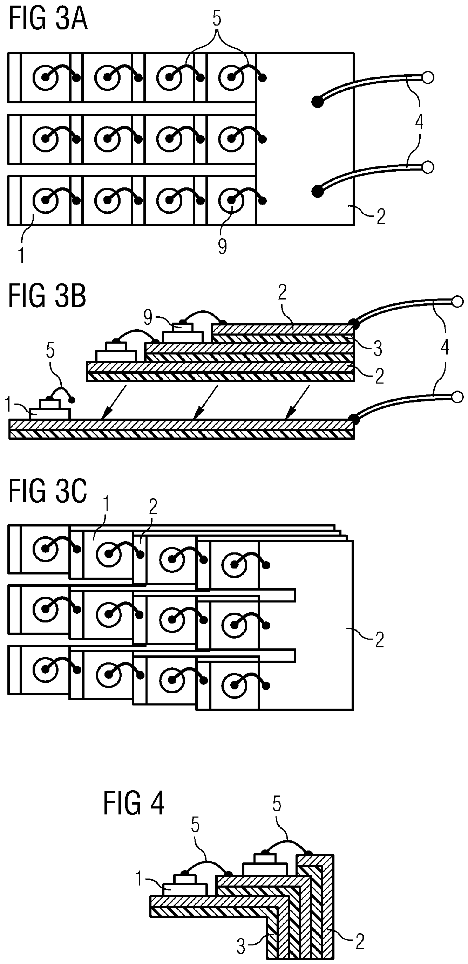

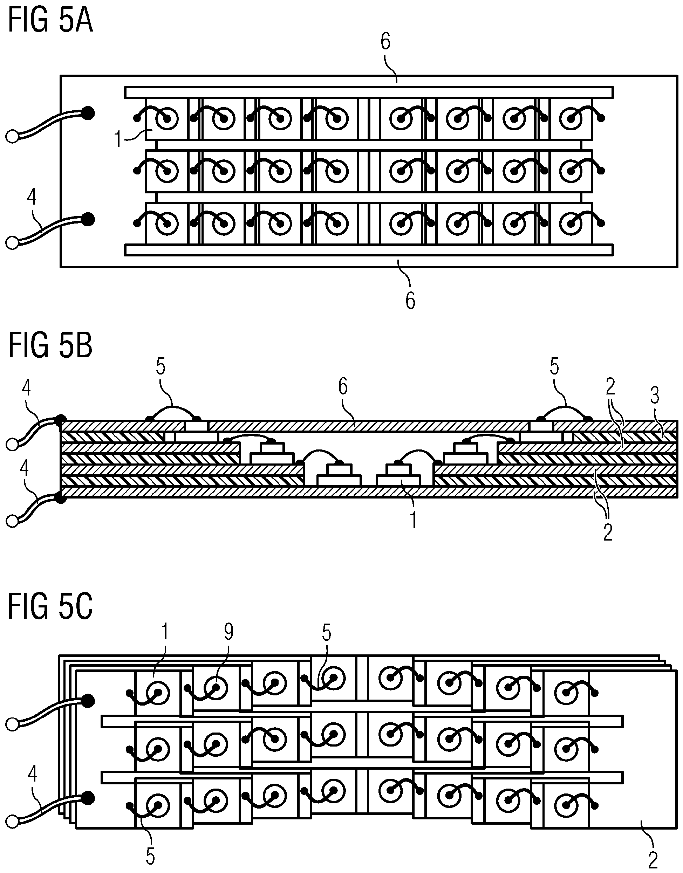

Wird zur genauen Darstellung die Betrachtungsrichtung direkt auf die Licht emittierenden Flächen der LEDs gewählt, so ist entsprechend die Front der LEDs sichtbar. Dabei sind die LED-Elemente flächig eng nebeneinander gepackt. In dieser Ansicht, wie sie in den Figuren 3A, 3C und 5A wiedergegeben ist, ist erkennbar, dass die Mehr-Folien-Sandwich-Bauweise eine stufenartige Struktur aufweist. Dabei enden die Folien in Richtung auf den Rand der mehrlagigen Metallfolie sukzessive derart, dass auf jedem freigelegten Ende oder Rand einer Metallfolienebene mindestens ein LED platzierbar ist. Die Kontaktierung geschieht über entsprechende Kontaktdrähte.

Bei der durch die Erfindung ermöglichten engen Packung von LEDs auf einem Träger ist es weiterhin vorteilhaft, wenn zusätzlich zur stufenförmigen Ausbildung die beispielsweise auf einem Finger eines kammförmigen Trägers aufgebrachten LEDs seriell geschaltet sind. Dabei werden jeweils von einem Anschlusspad/Anschlussfleck, der sich auf der Vorderseite eines LED-Chips befindet, Kontaktdrähte beziehungsweise Bonddrähte zu benachbarten entsprechend geschalteten Metallfolien gezogen. Somit ergibt sich eine serielle Schaltung der auf einem Finger vorhandenen stufenförmig platzierten LEDs.

Weiterhin ist es vorteilhaft, wenn zusätzlich zu seriellen Verschaltungen zumindest partiell parallel geschaltete Bereiche ausgebildet sind. Besondere Vorteile ergibt eine Bauform, die neben der kompakten Bauweise eine gute Wärmeankopplung der LEDs auf die jeweilige Metallfolie vorsieht, wobei die Metallfolie vorzugsweise an einem rückwärtigen Ort mit einer Wärmesenke verbunden ist.

Es ist auch vorteilhaft, die in Sandwichform ausgebildete mehrlagige Anordnung von Metallfolien in einem Bereich, in dem keine LED-Belegung vorhanden ist, zu einer Seite, beispielsweise mit einem Winkel von 90°, zu versehen. Damit kann eine Kontaktierung oder Ableitung der Wärme in ein rückwärtig gelagertes System in einfacher Weise ausgeführt werden.

Im Folgenden werden anhand schematischer Figuren die Erfindung nicht einschränkende Ausführungsbeispiele wiedergegeben.
- Figur 1: zeigt den prinzipiellen Aufbau eines LED-Flächenstrahles mit großer Packungsdichte,
- Figur 2: zeigt die Darstellung eines Metallfolienkammes mit drei an den Enden der jeweiligen Finger platzierten LED-Chips,
- Figuren 3A, 3B und 3C: zeigen jeweils eine Aufsicht, eine Seitenansicht und eine dreidimensionale Ansicht eines LED-Flächenstrahlers,
- Figur 4: zeigt die Seitenansicht eines Metallfolienträgers mit zwischen gelegten Isolierschichten, der gebogen ausgeführt ist und partiell einen Kamm mit einem Finger im Schnitt wiedergibt,
- Figuren 5A, 5B und 5C: zeigen die Aufsicht, die Seitenansicht und die dreidimensionale Ansicht eines LED-Flächenstrahlers, der in symmetrischer doppelter Ausführung realisiert ist,
- Figur 6: zeigt das Prinzip eines Aufbaus für einen Flächenstrahler mit Beleuchtungsoptik und Kühlsystem.

Entsprechend der Erfindung werden die Licht emittierenden Dioden (LED) nicht auf einer gemeinsamen Fläche montiert, sondern es wird eine Sandwichbauweise, bestehend aus mehreren Metallfolien, vorgeschlagen, die zwischen liegend Isolierschichten aufweist. Entscheidend ist, dass mit dieser Bauweise lateral betrachtet eine sehr dichte Platzierung der LED-Chips möglich ist. Zusätzlich kann die im Betrieb der LEDs entwickelte Wärme über die Metallfolie jeweils von einem LED abgeleitet werden.

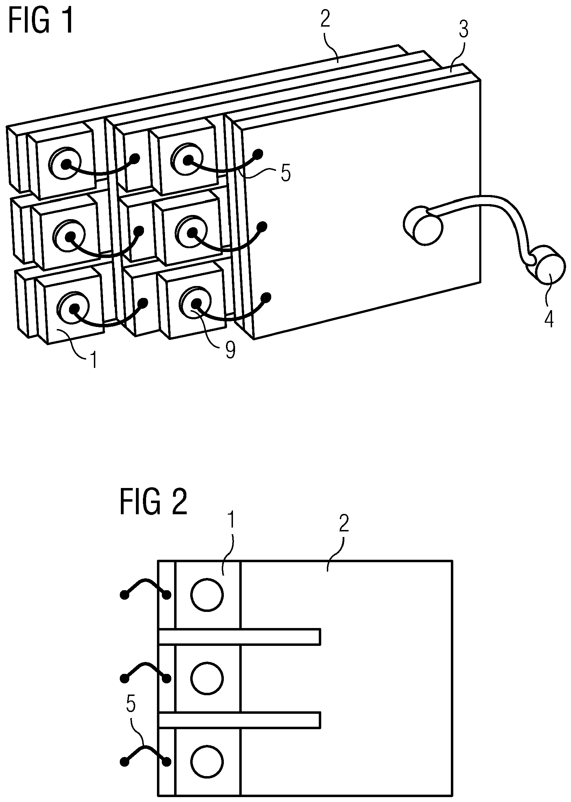

Dieses Belegungskonzept für einen Träger zur Realisierung eines Flächenstrahlers kann weiterhin vorteilhaft mit folgenden Merkmalen ausgestattet werden:
Für die Parallelschaltung verschiedener gruppenweise in Reihe geschalteter LEDs wird die Metallfolie beispielsweise wie in Fig. 1 oder Fig. 2 dargestellt in Form eines Kammes ausgeführt. In der Aufsicht ist der Hauptsteg des Kammes mit senkrecht erstrecktem Finger zu sehen, wobei die Mehrschichtfolien sich jeweils unterschiedlich weit bis zum Ende eines Fingers erstrecken. Somit wird eine gleichmäßige Stufenstruktur ausgebildet, wobei jeweils am Ende eines Fingers eine LED platziert ist, welche nach unten auf einer Metallfolie, bzw. nach oben zur nächsten entsprechend gepolten Metallfolie kontaktiert ist.

Es ist vorteilhaft, eine Kammstruktur in einem Metallfoliensystem durchgehend von oben bis unten auszubilden. Eine partielle Ausbildung ist jedoch ebenso möglich.

Zur besseren räumlichen und/oder thermischen Auslegung der Flächenstrahler kann die Metallfolie an überstehenden Enden derart angewinkelt sein, dass sie an übergeordnete Systeme leicht anzubauen ist.

Figur 1 zeigt den prinzipiellen Aufbau des LED-Flächenstrahlers mit entsprechender Stufung. Die LEDs sind grundsätzlich auf unterschiedlichen Metallfolien montiert. Die Metallfolien sind in Form einer Sandwichbauweise übereinander angeordnet. Die zwischen den Folien befindliche jeweilige Isolierschicht trägt das Bezugszeichen 3. Der Metallfolienkamm 2 hat entsprechend Figur 1 zwei Lagen und zusätzlich die obere Decklage, welche über den elektrischen Kontakt 4 nach außen hin angeschlossen ist. In Figur 1 ist eine Reihenschaltung von jeweils zwei LEDs angedeutet. Diese geschieht entsprechend über Kontaktdrähte 5 zwischen Metallfolie 2 und Bondpad 9 des nächstliegenden LEDs. Die unterste Anordnung von drei LEDs 1 ist über die entsprechenden LED-Chips zur unten liegenden in Figur 1 zur hintersten Metallfolie, die kammartig ausgebildet ist, kontaktiert und wird von dort ebenfalls über einen elektrischen Anschluss nach außen hin geschaltet.

Die Figur 2 gibt eine Darstellung des Metallfolienkammes 2 wieder. Dargestellt ist in der Aufsicht ein Hauptsteg mit drei nach links weisenden Fingern. Die LED-Chips 1 sind an den jeweiligen Enden montiert und nach unten hin über die Kontaktdrähte 5 zu anderen Metallfolien kontaktiert. Darüber hinaus sind die LED-Chips 1 derart auf der jeweiligen Metallfolie montiert, dass ihre Betriebswärme über diese Metallfolie abführbar ist. Auf den LED-Chips 1 sind mittig so genannte Bondpads 9 vorgesehen. Diese werden mit weiteren Kontaktdrähten 5, sogenannten Bonddrähten, nach oben hin kontaktiert. Die Metallfoliendicke entspricht idealer Weise der Dicke eines LED-Chips 1.

Die Figur 3A zeigt in der Aufsicht die Realisierung mehrerer in Reihe geschalteter LEDs. Der Metallfolienkamm 2 weist auch hier drei Finger auf. Auf jedem Finger ist eine stufenförmige Struktur von insgesamt vier Stufen dadurch ausgebildet, dass sich jede Metallfolie unterschiedlich weit auf einem Finger nach vorne bis zu dessen Ende hin erstreckt. Dabei ist die unterste Metallfolie vollständig ausgebildet. An der Spitze eines Fingers ist entsprechend jeweils ein Chip aufgebracht. Die nächst höhere Lage einer Metallfolie ist um die flächige Ausdehnung eines LED-Chips verkürzt. Auf entsprechenden freien Enden ist jeweils wieder ein weiterer LED-Chip 1 aufgebracht. In gleicher Weise werden in Figur 3A der dritte und der vierte LED montiert und über Kontaktdrähte 5 elektrisch seriell geschaltet.

Figur 3B zeigt die Seitenansicht einer Darstellung entsprechend Figur 3A, die teilweise in Explosionsdarstellung wiedergegeben ist. Die stufenartige Ausbildung der Sandwichstruktur eines Metallfolienmehrlagenträgers ist hier deutlich erkennbar. An der untersten und der obersten Metallfolie sind elektrische Anschlüsse 4 zur Kontaktierung nach außen hin vorgesehen. Die Metallfolien kontaktieren jeweils einen LED-Chip 1 von unten. Über Kontaktdrähte 5 wird das zu einem LED-Chip 1 gehörige Bondpad 9 mit einer höher, aber nicht darüber liegenden Metallfolie kontaktiert.

Figur 3C gibt eine dreidimensionale Ansicht einer Darstellung entsprechend der Figuren 3A oder 3B wieder.

Die Anordnung seriell geschalteter LEDs wird idealer Weise durch eine Verbindung von der Metallfolie auf ein entsprechendes Bondpad 9 der auf der darunter liegenden Metallfolie befindlichen LED realisiert.

Die elektrische Kontaktierung wird grundsätzlich derart vorgenommen, sei es seriell oder parallel, dass keinerlei Kurzschlüsse auftreten. Die Sandwichbauweise der Mehrlagenmetallfolie kann auch so ausgeführt werden, dass die Metallfolien der einzelnen Ebenen mehr als einen Kamm besitzen, wobei entsprechend Figur 5 oder auch entsprechend Figur 1 die oberste Metallfolie einen umlaufenden elektrischen Kontakt, mit dem sämtliche Kämme einer Ebene elektrisch versorgbar sind, aufweist.

Der gesamte Flächenstrahler besteht zumindest aus den LED tragenden Metallfolien und kann zusätzlich eine Beleuchtungsoptik aufweisen, sowie ein Kühlsystem.

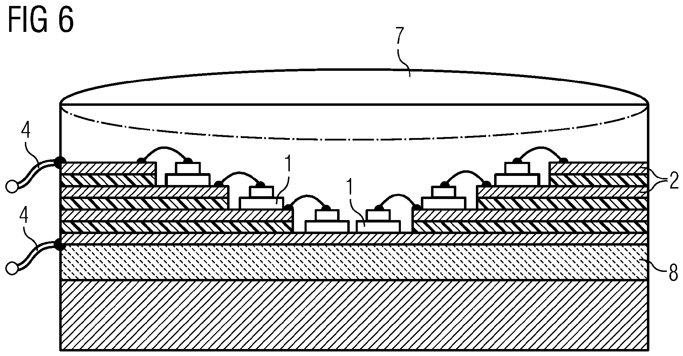

Figur 6 zeigt den prinzipiellen Aufbau eines Flächenstrahlers mit Beleuchtungsoptik 7 mit mittig positioniertem LED-Aufbau und unten liegendem Kühlsystem 8 beziehungsweise Wärmesenke oder Kühlkörper.

Figur 5A, 5B und 5C zeigen in der Reihenfolge eine Aufsicht, eine Seitenansicht und eine dreidimensionale Ansicht eines LED-Flächenstrahlers mit großer Packungsdichte. Dabei ist entsprechend Figur 5B leicht die symmetrische doppelte Ausführung eines bisher beschriebenen LED-Flächenstrahlers sichtbar. Mittels der elektrischen Verbindung 6, die auch durch eine Metallfolie realisierbar ist, wird die elektrische Kontaktierung sämtlicher LEDs gewährleistet.

Figur 5C zeigt die Darstellung entsprechend der Figuren 5A, 5B in der dreidimensionalen Ansicht. Die elektrische Verbindung 6 ist lediglich in Figur 5B erkennbar.

## Patentansprüche

1. Leuchtdioden-Anordnung, bestehend aus einer Vielzahl von benachbart angeordneten, gleich gerichtet abstrahlenden Leuchtdioden-Chips (1) zur Bildung einer flächig ausgedehnten Lichtquelle, wobei die Leuchtdioden-Chips auf einem metallischen Mehrfolienträger ({2; 3}) aufgebracht sind, der eine stufenartig ausgebildete Struktur mit mehreren Stufen aufweist, wobei
- die Stufen durch eine entsprechende Verkürzung oder Aussparung der jeweils darüber liegende Metallfolie (2) Z gebildet sind,
- die Leuchtdioden-Chips jeweils auf der Metallfolie einer Stufe platziert, elektrisch kontaktiert und zur Wärmeableitung auf die Metallfolien gekoppelt sind, und
- die Leuchtdioden-Chips jeweils mit der darüberliegenden Metallfolie auf der benachbarten Stufe elektrisch kontaktiert ({5; 9}) sind,
**dadurch gekennzeichnet, dass** der metallische Mehrfolienträger ({2; 3}) sandwichartig zwischen den Metallfolien (2) isolierende Zwischenschichten (3) aufweist.

2. Leuchtdioden-Anordnung nach Anspruch 1, bei der die Leuchtdioden-Chips zumindest gruppenweise seriell verschaltet sind.

3. Leuchtdioden-Anordnung nach Anspruch 1 oder 2, bei der die elektrische Schaltung der Leuchtdioden-Chips zumindest teilweise seriell und/oder zumindest teilweise parallel ausgelegt ist.

4. Leuchtdioden-Anordnung nach einem der vorhergehenden Ansprüche, bei der ein Leuchtdioden-Chip (1) über Kontaktdrähte (5) von einem elektrischen Anschlussfleck (9) zu einer benachbarten gegenpolig geschalteten Metallfolie gekoppelt ist.

5. Leuchtdioden-Anordnung nach einem der vorhergehenden Ansprüche bei der Metallfolien an deren von Leuchtdioden-Chips abgewandten Bereichen mittels elektrischer Anschlüsse (4) weiter kontaktiert sind.

6. Leuchtdioden-Anordnung nach Anspruch 1 bis 5, bei der die Metallfolien an einer den Leuchtdioden-Chips abgewandten Seite mit einer Wärmesenke (8) verbunden sind.

7. Leuchtdioden-Anordnung nach einem der vorhergehenden Ansprüche, bei der auf der Licht abstrahlenden Seite der Leuchtdioden-Chips eine Beleuchtungsoptik (7) vorhanden ist, die die Leuchtdioden-Anordnung zumindest partiell abdeckt und aus elektrisch nicht leitendem Material besteht.

8. Leuchtdioden-Anordnung nach einem der vorhergehenden Ansprüche, bei der eine mehrlagige Metallfolie mit zwischen liegenden Isolierschichten in einem nicht mit Leuchtdioden-Chips besetzten Bereich ungefähr um 90° gebogen ist.

9. Leuchtdioden-Anordnung nach einem der vorhergehenden Ansprüche, bei der nach außen gerichtete elektrische Anschlüsse (4) an eine der jeweiligen oberen und unteren Metallfolien angebracht sind.

10. Leuchtdioden-Anordnung nach einem der vorhergehenden Ansprüche, bei der Leuchtdioden-Chips auf kammartig ausgebildeten Strukturen von Metallfolien mit mehreren Fingern aufgebracht sind.

11. Leuchtdioden-Anordnung nach Anspruch 10, bei der mehrere Kammstrukturen an einer einzigen mehrlagigen Sandwich-Metallfolie dargestellt sind.

12. Leuchtdioden-Anordnung nach einem der vorhergehenden Ansprüche,
wobei die mindestens eine Leuchtdioden-Anordnung auf der Licht emittierenden Seite mit einer Optik (7) ausgestattet ist und auf der rückwärtigen Seite ein Kühlsystem (8) vorhanden ist.

13. Leuchtdioden-Anordnung, bei der mehrere Leuchtdioden-Anordnungen nach einem der vorhergehenden Ansprüche mechanisch und/oder elektrisch aneinander gekoppelt sind.

## Claims

1. Light-emitting diode arrangement, comprising a multiplicity of light-emitting diode chips (1) which are arranged in an adjacent fashion, emit in an identically directed fashion and serve for forming an areally extended light source, wherein the light-emitting diode chips are applied on a metallic multi-film carrier ({2; 3}), which has a structure embodied in a step-like fashion with a plurality of steps, wherein
- the steps are formed by a corresponding shortening or cutout of the respective overlying metal film (2),
- the light-emitting diode chips are in each case positioned, electrically contact-connected on the metal film of a step and coupled onto the metal films for the purpose of heat dissipation, and
- the light-emitting diode chips are in each case electrically contact-connected ({5; 9}) to the overlying metal film on the adjacent step,
**characterized in that** the metallic multi-film carrier ({2; 3}) has insulating intermediate layers (3) between the metal films (2) in a sandwich-like manner.

2. Light-emitting diode arrangement according to Claim 1, wherein the light-emitting diode chips are connected in series at least in groups .

3. Light-emitting diode arrangement according to Claim 1 or 2, wherein the electrical circuit of the light-emitting diode chips is designed at least partly in series and/or at least partly in parallel.

4. Light-emitting diode arrangement according to any of the preceding claims, wherein a light-emitting diode chip (1) is coupled via contact wires (5) from an electrical connection pad (9) to an adjacent metal film connected with opposite polarity.

5. Light-emitting diode arrangement according to any of the preceding claims, wherein metal films, at their regions remote from light-emitting diode chips, are further contact-connected by means of electrical connections (4).

6. Light-emitting diode arrangement according to Claim 1 to 5, wherein the metal films are connected to a heat sink (8) at a side remote from the light-emitting diode chips .

7. Light-emitting diode arrangement according to any of the preceding claims, wherein an illumination optical unit (7) is present on the light-emitting side of the light-emitting diode chips, said illumination optical unit at least partially covering the light-emitting diode arrangement and being composed of electrically nonconductive material.

8. Light-emitting diode arrangement according to any of the preceding claims, wherein a multilayered metal film with intermediate insulating layers is bent approximately by 90° in a region not occupied by light-emitting diode chips.

9. Light-emitting diode arrangement according to any of the preceding claims, wherein electrical connections (4) directed toward the outside are fitted to one of the respective upper and lower metal films.

10. Light-emitting diode arrangement according to any of the preceding claims, wherein light-emitting diode chips are applied on structures of metal films embodied in a comb-like fashion with a plurality of fingers .

11. Light-emitting diode arrangement according to Claim 10, wherein a plurality of comb structures are presented on a single multilayered sandwich metal film.

12. Light-emitting diode arrangement according to any of the preceding claims, wherein the at least one light-emitting diode arrangement is equipped with an optical unit (7) on the light-emitting side and a cooling system (8) is present on the rear side.

13. Light-emitting diode arrangement wherein a plurality of light-emitting diode arrangements according to any of the preceding claims are mechanically and/or electrically coupled to one another.

## Revendications

1. Agencement de diodes électroluminescentes constitué d'une pluralité de puces (1) à diodes électroluminescentes disposées en étant voisines et rayonnant dans la même direction pour former une source lumineuse s'étendant en nappe, les puces à diodes électroluminescentes étant déposées sur un support (2; 3) métallique à plusieurs feuilles, qui a une structure en paliers ayant plusieurs paliers, dans lequel
- les paliers sont formés par un raccourcissement correspondant ou un évidement correspondant de la feuille (2) métallique se trouvant au-dessus,
- les puces à diodes électroluminescentes sont contactées électriquement en étant placées sur la feuille métallique d'un palier et sont, pour l'évacuation de la chaleur, reliées aux feuilles métalliques et
- les puces à diodes électroluminescentes sont contactées (5; 9) électriquement par la feuille métallique se trouvant au-dessus sur le palier voisin,
**caractérisé en ce que** le support (2; 3) à feuilles multiples a des couches (3) intermédiaires isolantes prises en sandwich entre les feuilles (2) métalliques.

2. Agencement de diodes électroluminescentes suivant la revendication 1, dans lequel les puces à diodes électroluminescentes sont montées en série au moins groupe par groupe.

3. Agencement de diodes électroluminescentes suivant la revendication 1 ou 2, dans lequel le circuit électrique des puces à diodes électroluminescentes est conçu, au moins en partie, en série et/ou, au moins en partie, en parallèle.

4. Agencement de diodes électroluminescentes suivant l'une des revendications précédentes, dans lequel une puce (1) à diodes électroluminescentes est reliée par des fils (5) de contact d'une plage (9) de connexion électrique à une feuille métallique voisine montée en opposition de pôles.

5. Agencement de diodes électroluminescentes suivant l'une des revendications précédentes, dans lequel des feuilles métalliques sont, en outre, sur leurs parties éloignées des puces à diodes électroluminescentes, contactées au moyen de bornes (4) électriques.

6. Agencement de diodes électroluminescentes suivant l'une des revendications 1 à 5, dans lequel les feuilles métalliques sont, à un côté éloigné des puces à diodes électroluminescentes, reliées à un puits (8) de chaleur.

7. Agencement de diodes électroluminescentes suivant l'une des revendications précédentes, dans lequel, du côté émettant de la lumière des puces à diodes électroluminescentes, est prévue une optique (7) d'éclairage, qui recouvre, au moins en partie, l'agencement de diodes électroluminescentes et est constituée d'un matériau non-conducteur de l'électricité.

8. Agencement de diodes électroluminescentes suivant l'une des revendications précédentes, dans lequel une feuille métallique à plusieurs couches ayant des couches isolantes intermédiaires dans une partie qui n'est pas occupée par des puces à diodes électroluminescentes, est coudée à 90° environ.

9. Agencement de diodes électroluminescentes suivant l'une des revendications précédentes, dans lequel des bornes (4) électriques dirigées vers l'extérieur sont mises sur l'une des feuilles métalliques supérieure et inférieure.

10. Agencement de diodes électroluminescentes suivant l'une des revendications précédentes, dans lequel les puces à diodes électroluminescentes sont déposées sur des structures de type en peigne de feuilles métalliques ayant plusieurs doigts.

11. Agencement de diodes électroluminescentes suivant la revendication 10, dans lequel plusieurs structures en peigne sont représentées sur une feuille métallique prise en sandwich individuelle à plusieurs couches.

12. Agencement de diodes électroluminescentes suivant l'une des revendications précédentes, dans lequel le au moins un agencement de diodes électroluminescentes est équipé, du côté émettant de la lumière, d'une optique (7) et il y a un système (8) de refroidissement du côté arrière.

13. Agencement de diodes électroluminescentes, dans lequel plusieurs agencements de diodes électroluminescentes suivant l'une des revendications précédentes sont reliés mécaniquement et/ou électriquement entre eux.
